**Europäisches Patentamt**

**European Patent Office**

**Office européen des brevets**

(19)

(11) Veröffentlichungsnummer : **0 367 932 B1**

(12) ## EUROPÄISCHE PATENTSCHRIFT

(45) Veröffentlichungstag der Patentschrift :
**24.08.94 Patentblatt 94/34**

(51) Int. Cl.$^5$ : **H04J 4/00**

(21) Anmeldenummer : **89116171.3**

(22) Anmeldetag : **01.09.89**

(54) **Filterbank zum Frequenzmultiplexen bzw. Frequenzmultiplexen von Kanalsignalen.**

(30) Priorität : **08.11.88 DE 3837841**

(43) Veröffentlichungstag der Anmeldung :
**16.05.90 Patentblatt 90/20**

(45) Bekanntmachung des Hinweises auf die
Patenterteilung :
**24.08.94 Patentblatt 94/34**

(84) Benannte Vertragsstaaten :
**FR GB IT NL SE**

(56) Entgegenhaltungen :
**DE-U- 8 706 928**
**US-A- 4 412 325**

(56) Entgegenhaltungen :
**ICASSP '87, Dallas, 6.-9. April 1987, Seiten
2418-2421; J. CRITCHLEY : "Analysis and design of periodically time varying digital filters"
IEEE TRANSACTIONS ON COMMUNICA-
TIONS, Band COM-28, Heft 2, Februar 1980,
Seiten 244-249; K.M. Wong et al.:
"Commutativity and application of digital interpolation filters and modulators"**

(73) Patentinhaber : **ANT Nachrichtentechnik
GmbH
Gerberstrasse 33
D-71522 Backnang (DE)**

(72) Erfinder : **Göckler, Heinz, Dipl.-Ing.
Elbinger Strasse 52
D-7150 Backnang (DE)**

**EP 0 367 932 B1**

## Beschreibung

Die Erfindung bezieht sich auf eine Filterbank gemäß Oberbegriff der Patentansprüche 1 oder 2.

Filterbänke sind bekannt, beispielsweise durch den Aufsatz von Del Re und Emiliani "An Analytical Signal Approach for Transmultiplexers: Theory and Design" in IEEE Transactions on Communications, Vol. Com-30, No.7, Juli 1982, Seiten 1623 ff.

Filterbänke werden hauptsächlich in sogenannten Transmultiplexern zum Multiplexen oder Demultiplexen von FDM-Einzelkanälen eingesetzt. Transmultiplexer dienen der Umsetzung von FDM in TDM bzw. umgekehrt und finden hauptsächlich in der Satellitentechnik oder im Telefonnetz Anwendung. Gerade in der Satellitentechnik ist es oberstes Gebot, dafür zu sorgen, daß die Nutzlast so gering wie möglich ausfällt.

In der DE-U-8 706 928 wurden Filterbänke vorgestellt, welche in den einzelnen Kanalzweigen Filterkaskaden vorsehen.

In der EP-A-0 365 785 veröffentlicht am 02-05-90 wurden Filterbänke vorgestellt, bei denen nach bestimmten bzw. vor einer bestimmten gleichen Kaskadenstufe in allen Kanalzweigen ein Multiplizierer eingefügt ist, durch den die Koeffizienten der nachfolgenden Filter in allen Kanalzweigen bezüglich einer Kaskadenstufe identisch und reellwertig sind.

Der vorliegenden Erfindung lag die Aufgabe zugrunde, eine Filterbank der eingangs genannten Art anzugeben, für welche die erforderliche Rechenleistung und damit auch der Aufwand noch weiter vermindert sind.

Diese Aufgabe wurde gelöst mit den kennzeichnenden Merkmalen des Patentanspruches 1 bzw. 2.

Die erfindungsgemäße Filterbank weist den Vorteil eines kleineren Schaltungsaufwandes auf. Vorteilhafte Ausgestaltungen der Erfindung ergeben sich durch die Unteransprüche.

Es folgt nun die Beschreibung der Erfindung anhand der Figuren.

| | |
|---|---|
| Die Figuren 1a und b | zeigen die kaskadierte Filterbank gemäß erster Zusatzanmeldung mit einem Multiplizierer nach der ersten bzw. nach der zweiten Kaskadenstufe. |
| In den Figuren 2a und 2b | ist die Zusammenfassung des nachfolgenden komplexen Multiplizierers mit dem Filter der vorangehenden Kaskadenstufe schematisch dargestellt. |
| in Figur 3a | ist ein detaillierteres Blockschaltbild für den strichlinierten Block in Figur 2a dargestellt, und in Figur 3b die erfindungsgemäße Zusammenfassung ebenfalls in Form eines detaillierten Blockschaltbildes. |
| In Figur 4 | schließlich ist die Anordnung für eine erfindungsgemäße Zusammenfassung gemäß Figur 2b in Form eines Blockschaltbildes gezeigt, wobei die beiden Blöcke dem detaillierten Blockschaltbild gemäß Figur 3b entsprechen. |
| | Das hier gezeichnete Blockschaltbild gilt prinzipiell nicht nur für die Zusammenfassung des komplexen Multiplizierers mit der vorangehenden zweiten Stufe sondern auch für entsprechende Zusammenfassungen in den folgenden Stufen. |

Im folgenden wird versucht, darzustellen, wie sich die Rechenleistung durch die erfindungsgemäße Zusammenfassung vermindert.

Nach dem Stande der Technik gemäß DE-U-8 706 928 bzw. EP-A-0 365 785 entsprechend Figur 3a berechnen sich die Koeffizienten des Halbbandfilters nach Figur 3a als Prototypfilter mit reellen Koeffizienten und einer Nullphase von $\varphi_o$ zu (in Figur 3a : $\varphi_o = o$):

$$\underline{h}_l(v) = h(v) \cdot e^{j(2\pi f_l / f_A + \varphi_o)} = h_r(v) + j\,h_i(v) = h(v)\cos\left(2\pi v\frac{f_l}{f_A} + \varphi_o\right) + j\sin\left(2\pi v\frac{f_l}{f_A} + \varphi_o\right),$$

wobei $f_l$ die Mittenfrequenz des betrachteten Kanals am Eingang des ersten Filters der Kaskade und $f_A$ die zugehörige Abtastfrequenz ist. Die zeitveränderlichen Koeffizienten, Parameter k, der erfindungsgemäßen Lösung gemäß Figur 3b sind dann gegeben durch

$$\underline{h}_l(\nu, k) = \underline{h}_l(\nu)\, e^{-j\left(2\pi k \frac{f_l^I}{f_A^I} + \phi_o\right)}$$

$$= h_{rl}(\nu, k) + j\, h_{il}(\nu, k)$$

$$= \underline{h}_l(\nu)\left[\cos\left(2\pi k \frac{f_l^I}{f_A^I} + \phi_o\right) - j\sin\left(2\pi k \frac{f_l^I}{f_A^I} + \phi_o\right)\right]$$

also

$$\underline{h}_l(\nu, k) = h(\nu)\cos\left(2\pi\nu \frac{f_l}{f_A} + \varphi_o\right)\cos\left(2\pi k \frac{f_l^I}{f_A^I} + \phi_o\right)$$

$$+ h(\nu)\sin\left(2\pi\nu \frac{f_l}{f_A} + \varphi_o\right)\cdot\sin\left(2\pi k \frac{f_l^I}{f_A^I} + \phi_o\right)$$

$$+ j\left\{ h(\nu)\sin\left(2\pi\nu \frac{f_l}{f_A} + \varphi_o\right)\cos\left(2\pi k \frac{f_l^I}{f_A^I} + \phi_o\right)\right.$$

$$\left. - h(\nu)\cos\left(2\pi\nu \frac{f_l}{f_A} + \varphi_o\right)\sin\left(2\pi k \frac{f_l^I}{f_A^I} + \phi_o\right)\right\}$$

$$= h_r(\nu)\cos\left(2\pi k \frac{f_l^I}{f_A^I} \pm \varphi_o\right) + h_i(\nu)\sin\left(2\pi k \frac{f_l^I}{f_A^I} + \phi_o\right)$$

$$+ j\left\{ h_i(\nu)\cos\left(2\pi k \frac{f_l^I}{f_A^I} \pm \varphi_o\right) - h_r(\nu)\sin\left(2\pi k \frac{f_l^I}{f_A^I} + \phi_o\right)\right\}.$$

Mit dem Additionstheorem der Trigonometrie erhält man:

$$\underline{h}_l \, (\nu, k) = h \, (\nu) \cos \left[ 2 \, \pi \left( \nu \frac{f_l}{f_A} - k \, \frac{f_l^I}{f_A^I} \right) + \varphi_o - \phi'_o \right]$$

$$+ j \, h \, (\nu) \sin \left[ 2 \pi \left( \nu \frac{f_l}{f_A} - k \, \frac{f_l^I}{f_A^I} \right) + \varphi_o - \phi'_o \right]$$

$$= h \, (\nu) \, e^{j \left( 2 \pi \nu \frac{f_l}{f_A} + \varphi_o \right)} \cdot e^{- j \left( 2 \pi k \frac{f_l^I}{f_A^I} + \phi'_o \right)}$$

$$= h \, (\nu) \, e^{j \left( 2 \pi \left[ \nu \frac{f_l}{f_A} - k \, \frac{f_l^I}{f_A^I} \right] + \varphi_o - \phi'_o \right)}$$

$$= h_r (\nu, k) + j \, h_i \, (\nu, k) \, .$$

$f_l^I$ ist die Mittenfrequenz des betrachteten Kanals nach der Halbierung der Abtastfrequenz auf $f_A^I = f_A / 2$ im Zusammenhang der Filterung im ersten Filter der Kaskade. Falls $f_l < f_A^I$ ist, so gilt $f_l^I = f_l$. Die erste Filterstufe arbeitet mit reellem Eingangssignal und komplexem Ausgangssignal.

Für die Gleichung (1) und die vorangehenden Gleichungen sind noch die Parameter $\nu$ und $k$ näher zu erklären.

$\nu$ bezeichnet die Stelle des Koeffizienten im Filter.

$k$ bezeichnet die Zeitabhängigkeit der Koeffizienten.

Aufgrund dieser Zeitabhängigkeit ist die Symmetrie der Koeffizienten nicht mehr wie bei der Filterbank gemäß DE-U-8 706 928 und EP-A-0 365 785 vorhanden. Die Koeffizienten ändern sich sinusförmig, also periodisch. Es ist also nur eine beschränkte Zahl unterschiedlicher Koeffizientenwerte bereitzustellen und abzuspeichern. Im folgenden seien die Multiplikations- und Additionsraten für eine sechsstufige Filterkaskade berechnet.

Beim ersten Fall soll es sich dabei um eine Ausführung mit diskretem komplexen Multiplizierer nach der ersten Kaskadenstufe gemäß EP-A-0 365 785 entsprechend der Anordnung nach Figur 1a handeln. Hier ist eine Multiplikationsrate $M_{II} = 364 \cdot f_A^{VI}$ und eine Additionsrate von $A_{II} = 316 \cdot f_A^{VI}$ erforderlich.

Wird bei der vorgenannten Anordnung gemäß vorliegender Erfindung der komplexe Multiplizierer mit dem Filter der vorangehenden Kaskadenstufe zusammengefaßt, so werden dieses erste vorangehende Filter Nr. 1 zeitvariant und die folgenden Filter 2 bis Nr. 6 zeitinvariant mit reellen Koeffizienten, und die Multiplikationsrate errechnet sich wie folgt.

$$M_{III} = ( n_I + 3) \, f_A^I + 2 \sum_{q = II}^{VI} \frac{n_q + 5}{4} \, f_A^q$$

$$= \left[ 6 \cdot 32 + 4 \, (16 + 8) + 6 \, (4 + 2) + 8 \right] f_A^{VI}$$

$$M_{III} = 332\ f_A^{VI} < M_{II}$$

Additionsrate:

$$A_{III} = (n_I + 1)\ f_A^I + 2 \sum_{q=II}^{VI} \frac{n_q + 1}{2}\ f_A^q$$

$$= \left[ 4 \cdot 32 + 4\ (16 + 8) + 8\ (4 + 2) + 12 \right] f_A^{VI}$$

$$A_{III} = 284\ f_A^{VI} < A_{II}$$

Im folgenden seien die Merkmale der Filteranordnung gemäß vorliegender Erfindung aufgelistet.

Wie bei den Filterbänken gemäß erster Zusatzanmeldung sind alle Filter einer Kaskade nach dem zeitvarianten Filter, in das der Multiplizierer integriert ist, für alle L-Kanäle identisch und weisen reelle Koeffizienten auf. Da in dem zeitvarianten Filter die Koeffizientensymmetrie nicht vorliegt, ist der Rechenaufwand gemäß der vorliegenden Erfindung nur dann geringer als bei den vergleichbaren und entsprechenden Anordnungen gemäß EP-A-0 365 785 mit Ausnutzung der Symmetrie, wenn Stufe I zeitvariant und der Filtergrad $n_I = 3$ sind, siehe Beispiel.

Falls aus praktischen Gründen die Koeffizientensymmetrie nicht ausgenutzt werden sollte bei Anordnungen der EP-A-0 365 785, dann vermindert sich der Rechenaufwand für die erfindungsgemäßen Anordnungen gemäß vorliegender Erfindung in allen Fällen, unabhängig davon, wo das zeitvariante Filter angesiedelt ist, d. h. das zeitvariante Filter kann in allen Kaskadenstufen von der ersten bis einschließlich der letzten Stufe angeordnet sein.

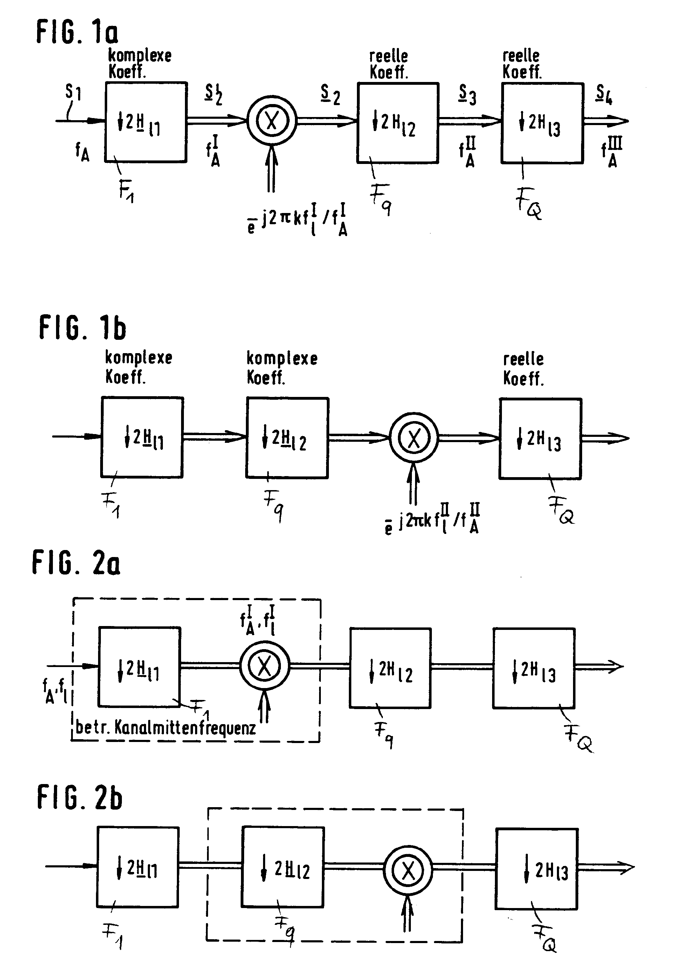

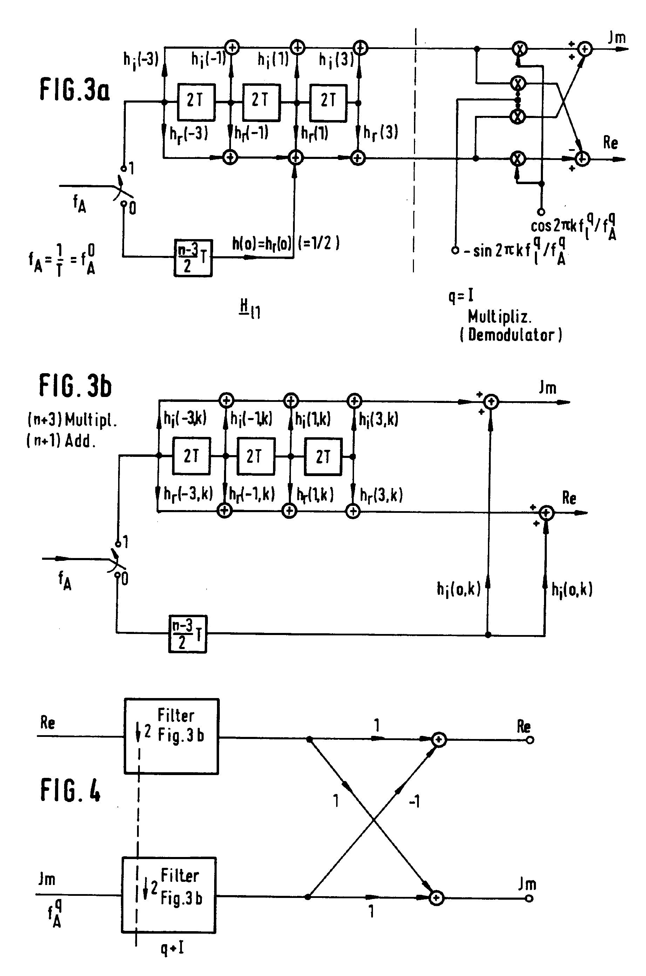

Selbstverständlich ist das erfindungsgemäße Prinzip der Zusammenfassung eines komplexen Multiplizierers mit dem Filter einer benachbarten Kaskade auch auf FDM-Multiplexer anwendbar, welche aus dem Demultiplexer, beispielsweise gemäß der Figuren 2a oder 2b, in einfacher Weise durch inverse Funktion, d. h. durch eine Betriebsweise in Rückrichtung, hervorgeht.

## Patentansprüche

1. Filterbank zum Frequenzdemultiplexen von L Kanalsignalen, für für L > 0 und L eine natürliche Zahl, bestehend aus L Transversalfiltern (nichtrekursive Filter, Filter mit endlich langer Dauer der Impulsantwort (FIR)), mit komplexwertigen Koeffizienten, für reellwertige Eingangssignale und mit komplexwertigen Ausgangssignalen, mit am Ausgang um den Faktor M reduzierter Abtastrate, wobei mindestens eines der L Filter durch eine Kaskadierung von mindestens 2 Filtern mit jeweils komplexwertigen Koeffizienten realisiert ist, wobei bei jedem Filter ($F_1, \dots F_q, \dots F_q$) innerhalb dieser Kaskade die Abtastrate um den Faktor $M_q > 1$ reduziert ist, mit

$$\prod_{q=1}^{Q} M_q = M,$$

wobei die Eingangsfilter ($F_1$) der Kaskade jeweils ein reellwertiges Eingangssignal aufnehmen und ein komplexwertiges Ausgangssignal abgeben und wobei die anderen Filter der Kaskade jeweils ein komplexwertiges Eingangssignal aufnehmen und ein komplexwertiges Ausgangssignal abgeben, wobei jeweils in den einzelnen Filterkaskaden zwischen zwei aufeinanderfolgenden gleichnumerierten Kaskadenstufen ein komplexer Multiplizierer eingefügt ist, mittels dem das komplexwertige Ausgangssignal des Filters der vorhergehenden Kaskadenstufe (q -1) bzw. das Eingangssignal mit der komplexen Folge einer derartigen abgetasteten, komplexen Trägerschwingung multipliziert wird, so daß die Filter der folgenden Kaskadenstufen (q) jeweils aus zwei separaten, identischen Tiefpaßfiltern mit reellen Koeffizienten bestehen, dadurch gekennzeichnet, daß der Multiplizierer mit dem Filter der vorangehenden Kaskadenstufe zusammengefaßt ist.

**2.** Filterbank zum Frequenzmultiplexen von L Kanalsignalen, für L > 0 und L eine natürliche Zahl, bestehend aus L Transversalfiltern (nichtrekursive Filter, Filter mit endlich langer Dauer der Impulsantwort (FIR)), mit komplexwertigen Koeffizienten, für komplexwertige Eingangssignale und reellwertige Ausgangssignale, mit am Ausgang um den Faktor M erhöhter Abtastrate, wobei mindestens eines der L Filter durch eine Kaskadierung von mindestens 2 Filtern mit jeweils komplexwertigen Koeffizienten realisiert ist, wobei bei dem Filter ($F_1, ... F_q, ... F_Q$) innerhalb dieser Kaskade die Abtastrate um den Faktor $M_q > 1$ erhöht ist, mit

$$\prod_{q=1}^{Q} M_q = M,$$

wobei die Q-1 ersten Filter ($F_1, ... F_q, ... F_{Q-1}$) der Kaskade jeweils ein komplexwertiges Eingangssignal aufnehmen und ein komplexwertiges Ausgangssignal abgeben und wobei die Ausgangsfilter der Kaskade jeweils ein komplexwertiges Eingangssignal aufnehmen und ein reellwertiges Ausgangssignal abgeben, wobei jeweils in den einzelnen Filterkaskaden vor der gleichen Kaskadenstufe ein komplexer Multiplizierer eingefügt ist, durch den das komplexwertige Ausgangssignal des Filters der vorangehenden Kaskadenstufe bzw. das Eingangssignal mit der komplexen Folge einer derartigen abgetasteten, komplexen Trägerschwingung multipliziert wird, daß die Filter der vorangehenden Kaskadenstufen jeweils aus zwei separaten, identischen Tiefpaßfiltern mit reellen Koeffizienten bestehen, dadurch gekennzeichnet, daß der Multiplizier mit dem Filter der nachfolgenden Kaskadenstufe zusammengefaßt ist.

**3.** Filterbank nach Anspruch 1 oder 2, dadurch gekennzeichnet, daß der Faktor M in 2 Faktoren zerlegt wird mit einer Zweier-Potenz $2^i$ als erstem Faktor und einem zweiten Faktor, der gleich $M/2^i$ ist, mit i gleich einer natürlichen Zahl.

**4.** Filterbank nach Anspruch 3, dadurch gekennzeichnet, daß der Zweier-Potenzfaktor $2^i$ durch eine Kaskade von i Filtern mit jeweils $M_q = 2$ realisiert ist.

**5.** Filterbank nach Anspruch 4, dadurch gekennzeichnet, daß die Filter dieser Kaskade jeweils als komplexe Halbbandfilter realisiert sind.

**6.** Filterbank nach einem der vorhergehenden Ansprüche, dadurch gekennzeichnet, daß die komplexe Trägerschwingung der Funktion $e^{-j2\pi k f_l^q/f_A^q}$ genügt, wobei k die Nummer der Abtastprobe (diskrete Zeitvariable) $f_l^q$ die Kanal-Bandmittenfrequenz des Kanals l in der q. Kaskadenstufe bedeuten.

## Claims

**1.** Filter bank, for the frequency division demultiplexing of L channel signals for L > 0 and L a natural number, consisting of L transverse filters (non-recursive filters, filters with finitely long duration of the pulse response (FIR)) with complex value coefficients, for real value input signals and with complex value output signals, with a scanning rate reduced by the factor M at the output, wherein at least one of the L filters is realised by a cascading of at least two filters each with complex value coefficients, wherein the scanning rate reduced by the factor $M_q > 1$ for each filter ($F_1 ... F_q ... F_Q$) within this cascade, wherein

$$\prod_{q=1}^{Q} M_q = M,$$

wherein the input filters ($F_1$) of the cascade each receive a real value input signal and deliver a complex value output signal, wherein the other filters of the cascade each receive a complex value input signal and deliver a complex value output signal, wherein a complex multiplier, by means of which either the complex value output signal of the filter of the preceding cascade stage (q-1) or the input signal is multiplied by the complex sequence of a complex carrier oscillation scanned in such a manner, is inserted into the individual filter cascades between each two successive equally numbered cascade stages so that the filters of the following cascade stages (q) each consist of two separate identical low-pass filters with real co-efficients, characterised thereby, that the multiplier is combined with the filter of the preceding filter stage.

2. Filter bank, for the frequency division multiplexing of L channel signals for L > 0 and L a natural number, consisting of L transverse filters (non-recursive filters, filters with finitely long duration of the pulse response (FIR)) with complex value coefficients, for complex value input signals and real value output signals, with a scanning rate increased by the factor M at the output, wherein at least one of the L filters is realised by a cascading of at least two filters each with complex value coefficients, wherein the scanning rate increased by the factor $M_q$ 1 for each filter ($F_1$ ... $F_q$ ... $F_Q$) within this cascade, wherein

$$\prod_{q=1}^{Q} M_q = M,$$

wherein the Q-1 first filters ($F_1$ ... $F_q$ ... $F_{Q-1}$) each receive a complex value input signal and deliver a complex value output signal, wherein the output filters of the cascade each receive a complex value input signal and deliver a real value output signal, wherein a complex multiplier, by means of which either the complex value output signal of the filter of the preceding cascade stage or the input signal is multiplied by the complex sequence of a complex carrier oscillation scanned in such a manner, is inserted into the individual filter cascades before the same cascade stage, that the filters of the preceding cascade stages each consist of two separate identical low-pass filters with real co-efficients, characterised thereby, that the multiplier is combined with the filter of the following cascade stage.

3. Filter bank according to claim 1 or 2, characterised thereby, that the factor M is resolved into two factors with a power $2^i$ of two as first factor and a second factor which is equal to $M/2^i$, wherein i is equal to a natural number.

4. Filter bank according to claim 3, characterised thereby, that the factor of the power $2^i$ of two is realised by a cascade of i filters each with $M_q = 2$.

5. Filter bank according to claim 4, characterised thereby, that the filters of this cascade are each realised as complex half-band filters.

6. Filter bank according to one of the preceding claims, characterised thereby, that the complex carrier oscillation conforms to the function $e^{-j2\pi k f_l^q / f_A^q}$, wherein k signifies the number of the scanning probe (discrete time variable) and $f_l^q$ signifies the channel band centre frequency of the channel l of the cascade stage q.

**Revendications**

1. Banc de filtres pour le multiplexage/le démultiplexage par répartition en fréquence des signaux de L canaux, avec L > 0 et L, nombre naturel, constitué de L filtres transversaux (filtres non récursifs, filtres à longue durée finie de la réponse impulsionnelle (FIR)), à coefficients complexes pour signaux d'entrée réels et à signaux de sortie complexes, avec, à la sortie, une cadence d'échantillonnage réduite du facteur M, banc de filtres dans lequel au moins l'un des L filtres est réalisé par un montage en cascade d'au moins deux filtres à, chacun, coefficients complexes, dans lequel, à chaque filtre ($F_1$, ... $F_q$, ... $F_Q$) existant à l'intérieur de cette cascade, la cadence d'echantillage est réduite du facteur $M_q > 1$, avec

$$\prod_{q=1}^{Q} M_q = M,$$

dans lequel les filtres d'entrée (F₁) de la cascade reçoivent chacun un signal d'entrée réel et émettent un signal de sortie complexe et dans lequel les autres filtres de la cascade reçoivent chacun un signal d'entrée complexe et émettent un signal de sortie complexe, dans lequel, dans les différentes cascades de filtre, entre deux étages successifs de la cascade de même numéro, est inséré un multiplicateur complexe au moyen duquel on multiplie le signal de sortie complexe du filtre de l'étage précédent de la cascade (q-1) ou le signal d'entrée par la suite complexe d'une onde porteuse complexe, échantillonnée de façon telle que les filtres des étages suivants de la cascade (q) soient chacun constitués de deux filtres passe-bas distincts identiques, à coefficients réels, banc de filtres caractérisé par le fait que le multiplicateur est regroupé avec le filtre de l'étage précédent de la cascade.

2. Banc de filtres pour le multiplexage/le démultiplexage par répartition en fréquence des signaux de L canaux, avec L > 0 et L, nombre naturel, constitué de L filtres transversaux (filtres non récursifs, filtres à longue durée finie de la réponse impulsionnelle (FIR)), à coefficients complexes pour signaux d'entrée complexes et à signaux de sortie réels, avec, à la sortie, une cadence d'échantillonnage augmentée du facteur M, banc de filtres dans lequel au moins l'un des L filtres est réalisé par un montage en cascade d'au moins deux filtres à, chacun, coefficients complexes, dans lequel, à chaque filtre ($F_1, ... F_q, ... F_Q$) existant à l'intérieur de cette cascade, la cadence d'échantillonnage est réduite du facteur $M_q > 1$, avec

$$\prod_{q=1}^{Q} M_q = M,$$

dans lequel les Q-1 premiers filtres ($F_1, ... F_q, ... F_{Q-1}$) de la cascade reçoivent chacun un signal d'entrée complexe et émettent un signal de sortie complexe et dans lequel les filtres de sortie de la cascade reçoivent chacun un signal d'entrée complexe et émettent un signal de sortie réel, dans lequel, dans chacune des différentes cascades de filtres, avant le même étage de la cascade, est inséré un multiplicateur au moyen duquel on multiplie le signal de sortie complexe du filtre de l'étage précédent de la cascade ou le signal d'entrée par la suite complexe d'une onde porteuse complexe, échantillonnée de façon telle que les filtres des étages précédents de la cascade soient chacun constitués de deux filtres passe-bas distincts, identiques, à coefficients réels, banc de filtres caractérisé par le fait que le multiplicateur est regroupé avec le filtre de l'étage suivant de la cascade.

3. Banc de filtres selon la revendication 1 ou 2, caractérisé par le fait que le facteur M se décompose en deux facteurs avec une puissance de deux $2^i$ comme premier facteur et un second facteur qui est égal à $M/2^i$, i étant égal à un nombre naturel.

4. Banc de filtres selon la revendication 3, caractérisé par le fait que le facteur puissance de deux $2^i$ est réalisé par une cascade de i filtres ayant chacun comme facteur $M_q = 2$.

5. Banc de filtres selon la revendication 4, caractérisé par le fait que les filtres de cette cascade sont chacun réalisés sous forme de filtres demi-bande complexes.

6. Banc de filtres selon l'une des revendications précédentes, caractérisé par le fait que l'onde porteuse complexe satisfait la fonction $e^{-j2\pi k f_1^q/f_A^q}$ k étant le numéro de l'épreuve d'échantillonnage (variable discrète en fonction du temps) et $f_1^q$ étant la fréquence centrale de la bande passante du canal 1 dans l'étage d'ordre q de la cascade.

# FIG. 1a

komplexe
Koeff.

reelle
Koeff.

reelle
Koeff.

$S_1$    $\downarrow 2 \underline{H}_{l1}$    $\underline{S}_2'$    ⊗    $\underline{S}_2$    $\downarrow 2 H_{l2}$    $\underline{S}_3$    $\downarrow 2 H_{l3}$    $\underline{S}_4$

$f_A$    $f_A^I$    $f_A^{II}$    $f_A^{III}$

$\mathcal{F}_1$    $\mathcal{F}_q$    $\mathcal{F}_Q$

$\bar{e}^{\,j2\pi k f_l^I / f_A^I}$

# FIG. 1b

komplexe
Koeff.

komplexe
Koeff.

reelle
Koeff.

$\downarrow 2 \underline{H}_{l1}$    $\downarrow 2 \underline{H}_{l2}$    ⊗    $\downarrow 2 H_{l3}$

$\mathcal{F}_1$    $\mathcal{F}_q$    $\mathcal{F}_Q$

$\bar{e}^{\,j2\pi k f_l^{II} / f_A^{II}}$

# FIG. 2a

$f_A^I, f_l^I$

$f_A, f_l$    $\downarrow 2 \underline{H}_{l1}$    ⊗    $\downarrow 2 H_{l2}$    $\downarrow 2 H_{l3}$

$\mathcal{F}_1$    $\mathcal{F}_q$    $\mathcal{F}_Q$

betr. Kanalmittenfrequenz

# FIG. 2b

$\downarrow 2 \underline{H}_{l1}$    $\downarrow 2 H_{l2}$    ⊗    $\downarrow 2 H_{l3}$

$\mathcal{F}_1$    $\mathcal{F}_q$    $\mathcal{F}_Q$

FIG.3a

$f_A = \frac{1}{T} = f_A^0$

$h_i(-3)$  $h_i(-1)$  $h_i(1)$  $h_i(3)$

2T   2T   2T

$h_r(-3)$  $h_r(-1)$  $h_r(1)$  $h_r(3)$

1

0

$\frac{n-3}{2}T$   $h(o) = h_r(o)$ $(=1/2)$

$\underline{H}_{l1}$

Jm

Re

$\cos 2\pi k f_l^q / f_A^q$

$-\sin 2\pi k f_l^q / f_A^q$

q = I
Multipliz.
(Demodulator)

FIG.3b

(n+3) Multipl.
(n+1) Add.

$h_i(-3,k)$  $h_i(-1,k)$  $h_i(1,k)$  $h_i(3,k)$

2T   2T   2T

$h_r(-3,k)$  $h_r(-1,k)$  $h_r(1,k)$  $h_r(3,k)$

1

0

$f_A$

$\frac{n-3}{2}T$

$h_i(o,k)$   $h_i(o,k)$

Jm

Re

FIG.4

Re   Filter
↓2 Fig.3b

Jm   Filter
↓2 Fig.3b

$f_A^q$

q+I

1

1   -1

1

Re

Jm